# EUROPÄISCHE PATENTSCHRIFT

(11) **EP 2 175 995 B1**
(45) Veröffentlichungstag und Bekanntmachung des Hinweises auf die Patenterteilung: **23.05.2018**
(21) Anmeldenummer: 08784858.6
(22) Anmeldetag: 17.07.2008
(51) Int. Cl.: B01L 3/00, G04F 5/14

(54) **VERFAHREN ZUR HERSTELLUNG EINER ZELLE MIT EINER KAVITÄT**
METHOD FOR THE PRODUCTION OF A CELL WITH A CAVITY
PROCEDE DE FABRICATION D' UNE CELLULE PRESENTANT UNE CAVITE

(30) Priorität: 26.07.2007 DE 102007034963
(43) Veröffentlichungstag der Anmeldung: 21.04.2010
(73) Patentinhaber: Henning Völlm, 54411 Hermeskeil (DE)
(72) Erfinder: VÖLLM, Henning, 54411 Hermeskeil (DE); SCHMID, Ulrich, 66125 Saarbrücken (DE); SCHÜTZE, Andreas, 66386 St. Ingbert (DE); SEIDEL, Helmut, 82319 Starnberg (DE); FEILI, Dara, 66123 Saarbrücken (DE)
(74) Vertreter: Samson & Partner Patentanwälte mbB
(86) Internationale Anmeldenummer: PCT/EP2008/005878
(87) Internationale Veröffentlichungsnummer: WO 2009/012939

(56) Entgegenhaltungen:
- US-A1- 2006 022 761
- US-B1- 6 570 459

## Beschreibung

### Gebiet der Erfindung

Die Erfindung betrifft eine Zelle mit einer Kavität und einer die Kavität umgebenden Wandung, sowie ein Bauelement und Verfahren zur Herstellung einer derartigen Zelle und die Verwendung derselben.

### Hintergrund der Erfindung

Zellen mit einer Kavität, insbesondere sogenannte Dampfzellen, werden im Allgemeinen in verschiedenen industriellen und wissenschaftlichen Bereichen eingesetzt. Das Feld ihrer Verwendung reicht von der grundlagenorientierten Experimentalphysik bis zur Biotechnologie, von der Raumfahrtforschung bis zu "Lab-on-a-Chip"-Anwendungen.

Insbesondere mit einem Reaktivgas gefüllte Dampfzellen werden dazu verwendet, als Resonatorelement in Atomuhren ein Zeitnormal zur Verfügung zu stellen. Dabei liefert ein Hyperfeinstrukturübergang von gasförmigen Alkalimetallen wie Cäsium oder Rubidium ein hochgenaues Frequenz- bzw. Zeitnormal.

Neben der seit längerem bekannten Methode, den Hyperfeinstrukturübergang mittels Mikrowellenbestrahlung zu induzieren, ist seit den letzten Jahren auch die Erzeugung des Hyperfeinstrukturübergangs mittels optisch induzierter Resonanz bekannt, das sogenannte "Coherent population trapping (CPT)".

Im Vergleich zur Induktion mittels Mikrowellenbestrahlung ermöglicht das CPT eine nicht unerhebliche Miniaturisierung von solchen reaktivgasgefüllten Dampfzellen und damit verbundener Komponenten, so dass die entsprechenden Atomuhren ebenfalls wesentlich kleiner gebaut werden können.

Insbesondere für den nicht stationären Einsatz sind derartige miniaturisierte Atomuhren trotz ihrer etwas geringeren Ganggenauigkeit von großem Interesse.

Als Anwendungsfelder für miniaturisierte Atomuhren - und damit miniaturisierte Dampfzellen - kommen insbesondere die nichtstationären Empfangsgeräte für Satellitennavigationssysteme wie GPS, GLONASS oder Galileo in Betracht. Im Vergleich zum Stand der Technik kann dann bereits mit den Signalen von drei statt bisher vier erforderlichen Satelliten die Position eines Objektes bestimmt werden; und das sogar mit höherer Genauigkeit.

Derartige miniaturisierte Uhren können ferner dazu dienen, die Signale in Kommunikationsnetzwerken sowie auch kryptographische Schlüssel zu synchronisieren.

Weiterhin ist es möglich, mit Hilfe reaktivgasgefüllter Dampfzellen hochgenaue Magnetfeldsensoren und Drehratensensoren vom Typus "Nuclear magnetic resonance gyroscope" (NMRG) zu bauen.

Während makroskopische Dampfzellen mit feinmechanischen Verfahren hergestellt werden, etwa indem Glaskapseln einzeln mit den gewünschten Stoffen befüllt und anschließend aufwendig, z.B. durch Glaslöten oder Glasbläserarbeiten verschlossen werden, gibt es für mikroskopische Dampfzellen Ansätze, diese mittels hermetischen Bondens von Silizium und / oder Glas zu fertigen.

In Analogie zum Herstellungsverfahren von makroskopischen Dampfzellen muss das Befüllen der mikroskopischen Dampfzellen spätestens vor deren hermetischem Verschließen erfolgen.

Hierzu sind aus dem Stand der Technik verschiedene Herstellungsverfahren bekannt, die sich primär in der Art der Befüllung unterscheiden.

Bei dem beispielsweise aus der amerikanischen Patentanmeldung US 2006/0022761 bekannten Verfahren zur Herstellung cäsiumgefüllter Dampfgaszellen wird in einen Silizium-Wafer mittels aus der Halbleitertechnik bekannter Verfahren eine durchgehende Ausnehmung geätzt, die den inneren Abmessungen der Dampfzelle entspricht. Mittels Anodischen Bondens wird der Silizium-Wafer mit einem Glas-Wafer verbunden, so dass die Ausnehmung im Silizium-Wafer einseitig verschlossen ist. In die so entstandene Kavität wird nun flüssiges Cäsium unter Stickstoff- bzw. Argonatmosphäre eingebracht und anschließend die Kavität durch Anodisches Bonden mit einem weiteren Glas-Wafer hermetisch verschlossen. Das dabei in der Kavität miteingeschlossene Gas - etwa Argon oder Stickstoff - dient während des späteren Einsatzes der Dampfzelle gleichzeitig als Puffergas.

In ähnlicher Weise wird bei dem aus der amerikanischen Patentschrift US 6900 702 B2 bekannten Verfahren Rubidium in eine Dampfzelle eingebracht und die Dampfzelle, die Bestandteil eines kompletten Frequenz-Normals auf Basis von Silizium-Wafern ist, anschließend verschlossen.

Beide Schriften lehren weiterhin, die verschlossene Zelle mit dem darin eingeschlossenen Alkalimetall mittels eines Lasers oder anderer geeigneter Heizstrukturen zu erhitzen und so den gewünschten Dampfdruck in der Zelle einzustellen.

In der Veröffentlichung von Li-Anne Liew et. al. in Appl. Phys. Lett. Vol. 84 No 14 vom 05. April 2004 wird eine alternative Befülltechnik für Dampfdruckzellen auf Waferbasis vorgestellt. Statt reinen Cäsiums wird hier Cäsiumchlorid zusammen mit Bariumazid in die Zelle eingebracht und nach dem Verschließen der Zelle zur chemischen Reaktion gebracht, bei der atomares Cäsium entsteht.

Die beschriebenen Herstellungsverfahren weisen Nachteile auf, die einer kostengünstigen Serienproduktion im Wege stehen.

Generell gilt, dass Alkalimetalle wie Cäsium und Rubidium sehr reaktionsfreudig sind und insbesondere mit Wasserdampf und Sauerstoff extrem reagieren. Im Falle ihrer elementaren Verarbeitung in den zuerst beschriebenen Verfahren ist es daher notwendig, diese Elemente in geschützter Atmosphäre zu verarbeiten. Die Befüllung erfordert daher eine sehr spezielle Anlagentechnik und erhebliche Anstrengungen, um die Sicherheit des Prozesses zu gewährleisten.

Das auf der Reaktivgasbildung durch chemische Reaktion beruhende Verfahren hingegen hat den Nachteil, dass es sich bei den Aziden - und insbesondere bei Bariumazid - um hochgefährliche Substanzen handelt, die als Sprengstoff eingesetzt werden können. Diese dürfen in Europa nicht gehandelt oder transportiert werden und sind deswegen de facto nicht verfügbar. US 6,570,459 B1 offenbart eine Vorrichtung für eine Atomuhr mit einer Deck- und Bodenplatte sowie eine zwischen diesen eingefügte Mittelplatte mit einem Ausschnitt, die zusammen eine Zellenstruktur bilden. In einer Kavität ist ferner ein Cäsium Reservoir vorgesehen, in dem eine Dampfquelle, wie Cäsium, vorgehalten wird. Ausgehend von diesem Reservoir kann das gasförmige Cäsium Material durch einen Kanal in den Ausschnitt wandern. Im Übrigen wird auf die Patentschriften DE 692 05 307 T2 und DE 696 29 483 T2 verwiesen.

### Aufgabe der Erfindung

Aufgabe der vorliegenden Erfindung ist es, neben einer Zelle auch einen ihrer Bestandteile bereitzustellen, derart dass beide einfach herstellbar und zumindest weitgehend frei von den oben genannten Nachteilen sind.

### Kurzbeschreibung der Erfindung

Zur Lösung obiger Aufgabe stellt die vorliegende Erfindung ein Verfahren zur Herstellung einer gasbefüllbaren Zelle gemäß Anspruch 1 bereit.

Demnach umfasst eine hergestellte Zelle eine Kavität, eine die Kavität umgebende Wandung, und mindestens einen in der Wandung gelegenen Depotbereich für Material, welches durch Diffusion in die Kavität transferierbar ist. Der Depotbereich ist in der Wandung der Zelle an einer Stelle vorgesehen, an der er bestimmte durch Diffusion transferierbare Materialien aufnehmen und einlagern kann. Mit dem deponierten Material wird die Kavität im weiteren Herstellungsverfahren durch Ausdiffusion aus dem Depotbereich in die Kavität befüllt.

Die Wandung die Kavität schließt hermetisch gegen die Umgebung ab und das aus dem Depotbereich in die Kavität gelangte Material ist gasförmig.

Die Kavität im Inneren der Zelle ist für von außen einfallendes Licht optisch zugänglich, also zumindest teilweise lichtdurchlässig, beispielsweise weil sie mindestens einen Bereich aus Glas aufweist.

Die Lichtstrahlen können die Zelle vorzugsweise in einem durchgehenden Strahlengang passieren. Dazu können die Kavität nach wenigstens zwei Seiten abschließende Deck- oder Substratschichten als lichtdurchlässige Schichten oder als Schichten mit geeigneten lichtdurchlässigen Bereichen ausgelegt sein.

In einer anderen Ausführungsform kann der Lichtstrahl auf wenigstens einer Seite innerhalb der Kavität mindestens einmal reflektiert werden. Zwischen Lichteintritt in die Kavität und Lichtaustritt des reflektierten Strahls können sowohl große wie auch kleine Ablenkwinkel vorgesehen sein.

Das für den Eintritt in die Zelle vorgesehene Licht kann beliebige Bereiche des elektromagnetischen Spektrums umfassen. Beispielsweise können auch an das sichtbare Lichtspektrum angrenzende oder weiter entfernte nicht sichtbare Wellenlängenbereiche verwendet werden. Die durchlässigen Bereiche in den Substratschichten können in geeigneter Weise für den Durchgang der vorgesehenen Wellenlängen der elektromagnetischen Strahlung ausgelegt werden.

Die Wandung der Zelle ist aus mindestens zwei Substratschichten aufgebaut, vorzugsweise sind es drei Substratschichten. Ist eine Zelle aus drei Substratschichten zusammengesetzt, kann in der mittleren der drei Schichten die Kavität vorgesehen sein. Die obere und untere Schicht können die die Kavität gegen den Außenraum abschließende Deckschichten sein.

Wenn die Zelle aus nur zwei Substratschichten gebildet wird, kann sich die Kavität vorzugsweise in der ersten Schicht befinden, und die zweite Schicht als die die Kavität abschließende Deckschicht dienen.

Die Schichten sind fest miteinander verbunden und bilden die Wandung der Zelle.

Während es prinzipiell möglich ist, eine derartige Zelle oder die Wandung zumindest teilweise aus Metall zu fertigen, um auch die Vorteile metallischer Werkstoffe nutzen zu können, werden vorzugsweise Substratmaterialien aus der Halbleitertechnik und/oder aus der Mikrotechnik, insbesondere Mikroelektronik, vorzugsweise Silizium und Glas, eingesetzt, die den Einsatz von etablierten Fügeverfahren auf Waferlevel ermöglichen, wie beispielsweise anodisches Bonden.

Vorgesehen ist auch die Verwendung von strukturierten keramischen oder glaskeramischen Verbundwerkstoffen zur Realisierung der Mikrokavität.

Weiterhin kann die Zelle mit Heizstrukturen versehen sein, die in die Wandung integriert sind oder um die Wandung oder in einem an die Wandung angrenzenden Bereich angeordnet sind.

Die im Depotbereich deponierten Materialien können auch mit der Atmosphäre reaktiv wechselwirkende Substanzen sein, beispielsweise Rubidium oder Cäsium.

Vorzugsweise ist der Depotbereich gegen den der Kavität abgewandten Bereich mit mindestens einer Diffusionssperre abgegrenzt, um eine Diffusion des deponierten Materials in eine von der Kavität wegweisende Richtung zu verhindern.

Ein ein Vorprodukt der erfindungsgemäßen Zelle darstellendes Bauelement enthält einen Wandungsabschnitt, der derart aufgebaut ist, dass in ihm eine Ausnehmung und mindestens ein Depotbereich zur Aufnahme von Material ausbildbar sind, welches nach Einbringen in den Depotbereich und nach dem Ausbilden der Ausnehmung aus dem Depotbereich in die Ausnehmung diffundiert und dort gasförmig vorliegt.

Die Ablagerung von diffundierbarem Material und gegebenenfalls zusätzlichen Materialien im Depotbereich erfolgt durch Ionenimplantation. Dies ist ein besonders geeignetes, kommerziell verfügbares Verfahren mit dem weiteren Vorteil, dass sie unter Vakuum stattfindet und deshalb Reaktionen des abzulagernden, als Reaktivstoff wirkenden Materials bzw. seines Gases mit den Elementen der Atmosphäre ausgeschlossen sind. So wird vorteilhaft ein ungefährliche Herstell- und Befüllungsmethode bereitgestellt, die für eine kostengünstige Serienproduktion geeignet ist.

Zur Ausbildung der Kavität im Inneren der Zelle wird eine Aussparung oder eine Aushöhlung in einer Substratschicht vorgenommen. Diese Aussparung kann durch Ätzen im Substratmaterial hergestellt werden.

In bevorzugter Ausführung wird in einem Halbleitersubstrat, analog zu den aus dem Stand der Technik bekannten Verfahren, etwa mittels photolithographisch definierten Ätzens, eine Kavität erzeugt, die später für die Aufnahme des reaktiven Gases dienen soll.

Die mit der Aussparung versehene Substratschicht und die eine oder mehreren Deckschichten können mittels anodischer Waferbondtechnik miteinander verbunden werden und bilden dann in ihrem Innern eine gegen den Außenraum hermetisch abgeschlossenen Kavität aus.

Zur Befüllung der verschlossenen Zelle wird das im Reservoirbereich eingelagerte Material durch Diffusion ausgetrieben. Dabei kann durch geeignetes Erhitzen eine gewünschte Konzentration des reaktiven Gases innerhalb der Kavität eingestellt werden.

Die Zelle kann als Zeit- oder Frequenznormal oder zur Einstellung einer vorbestimmten Konzentration eines gasförmigen Materials in der Kavität durch gesteuerte Ausdiffusion eines dem Gas entsprechenden Materials aus dem Depotbereich verwendet werden. Auch eignet sich die Zelle zum Einsatz in einer Atomuhr, eines Magnetfeldsensors oder eines Drehratensensors, oder zur Synchronisation von Kommunikationsnetzwerken oder kryptographischen Schlüsseln.

### Kurzbeschreibung der Zeichnungen

Nachstehend wird die Erfindung anhand von Ausführungsbeispielen und den beigefügten schematischen Zeichnungen beschrieben in welchen zeigen
- Fig. 1: eine Explosionszeichnung eines ersten Ausführungsbeispiels einer erfindungsgemäßen Zelle;
- Fig. 2: eine Schnittzeichnung der Zelle nach Fig. 1;
- Fig. 3: die Implantation des Reaktivgasmaterials in den Depotbereich der Zelle nach Fig. 1;
- Fig. 4: eine Explosionszeichnung eines zweiten Ausführungsbeispiels einer erfindungsgemäßen Zelle;
- Fig. 5: eine Schnittzeichnung der Zelle nach Fig. 4; und
- Fig. 6: die Reflektion eines in die Zelle nach Fig. 4 einfallenden Lichtstrahls.

### Beschreibung bevorzugter Ausführungsformen

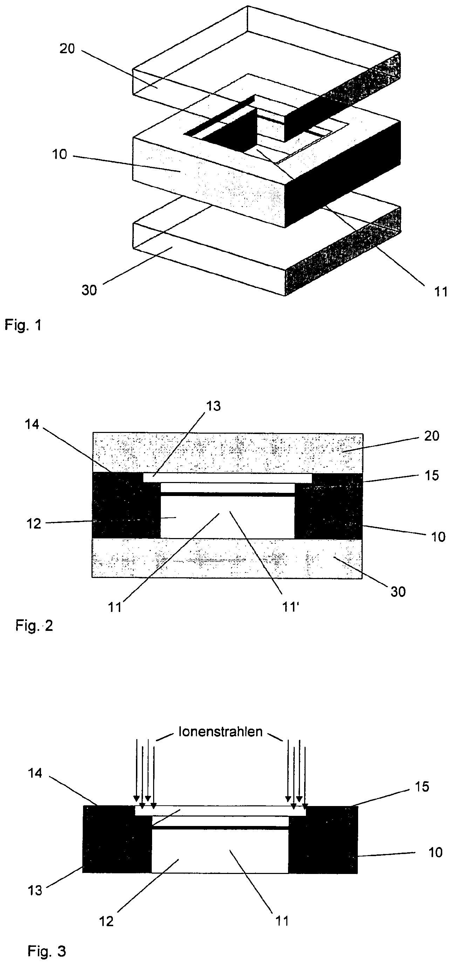

Die Figuren 1 bis 3 veranschaulichen den Aufbau einer Zelle aus drei ebenen Schichten bzw. Substratschichten 10, 20, 30. In der mittleren Schicht 10 befindet sich eine durch diese Schicht hindurchgehende quadratische Aussparung 11. Alternativ kann die Aussparung beliebige andere Formen annehmen. Die beiden äußeren Schichten 20 und 30 decken die Aussparung 11 ab. Der so gebildete Hohlraum wird im folgenden als Kavität 11' bezeichnet. Die Deckschichten 20, 30 bilden zusammen mit der Substratschicht 10 die die Kavität 11' hermetisch gegen den Außenraum abschließende Wandung der Zelle. Die Substratschicht 10 besteht aus Silizium. Als alternative Werkstoffe kommen typische Materialien aus dem Bereich der Mikrotechnik, wie strukturierte Keramiken oder Glaskeramiken bzw. weitere Halbleiter in Betracht. Die beiden Deckschichten 20, 30 bestehen aus einem lichtdurchlässigen Material, beispielsweise aus Glas und ermöglichen einen optischen Zugang zum inneren Hohlraum der Zelle.

Neben mechanischen Verfahren kann die Aussparung 11, wie aus der Halbleitertechnologie bekannt, mittels fotolithografischer Ätzverfahren hergestellt werden.

Im Ausführungsbeispiel der Figuren 1 bis 3 besteht die Aussparung 11 aus zwei Teilbereichen 12, 13, die unterschiedliche Querschnitte haben, so dass am Übergang zwischen beiden Teilbereichen 12, 13 eine Stufe ausgebildet ist. Eine derartig ausgeformte Aussparung 11 lässt sich durch zwei aufeinander folgende Ätzprozesse in einfacher Weise realisieren.

Fig. 2 veranschaulicht schematisch die Lage einer Diffusionsbarriere 14. Diese ist im Inneren der Substratschicht 10 vorgesehen ist und verläuft parallel zum gestuften Abschnitt des Teilbereichs 13. Innerhalb der mittleren Substratschicht 10, und zwar zwischen der ausgeformten Stufe und der Diffusionsbarriere 14, entsteht damit ein Reservoirbereich 15, der für die Deponierung eines Reaktivgasmaterials vorgesehen ist. Das Reaktivgasmaterial kann nur seitlich und in einer von der Diffusionsbarriere 14 wegweisenden Richtung (in Fig. 2 in Richtung nach oben) in die Kavität 11' hinein diffundieren.

Fig. 3 zeigt schematisch, wie der Reservoirbereich 15 einem lonenstrahl des gewünschten Reaktivgasmaterials ausgesetzt ist, um den Reservoirbereich 15 mit Reaktivgas-Ionen anzureichern. Hierzu kann eines der allgemein bekannten Ionenimplantationsverfahren mittels kommerziell verfügbarer Apparaturen durchgeführt werden. Die Deponierung des Reaktivgasmaterials erfolgt vor dem Verbinden der Substratschicht 10 mit den beiden Deckschichten 20, 30.

Da die Ionenimplantation unter Vakuum erfolgt und das Reaktivgasmaterial zunächst stabil in Form einer chemischen Verbindung vorliegt, werden Reaktionen des zu implantierenden Stoffes mit der Atmosphäre ausgeschlossen.

Nach der Ionenimplantation werden die Deckschichten 20, 30 mit der Substratschicht 10 verbunden, so dass die Kavität 11' im Innern der Zelle hermetisch nach außen abgeschlossen ist. Besondere Sicherheitsvorkehrungen zur Unterbindung chemischer Reaktionen des Reaktivstoffes, die beim Verschließen von Zellen nach dem Stand der Technik notwendig sind, müssen bei dem hier dargestellten Verfahren nicht getroffen werden.

Als besonders praktikabel hat sich das Anodische Waferbonden als Technik zum Verbinden der Zellenschichten 10, 20 und 30 erwiesen. Soll die Gaszelle später zusätzlich zum Reaktivgas ein Puffergas, etwa Stickstoff oder Argon, enthalten, so wird sie beim Verschließen einer entsprechenden Atmosphäre ausgesetzt, unter der die Substratschicht 10 mit den beiden Deckschichten 20, 30 verbunden wird.

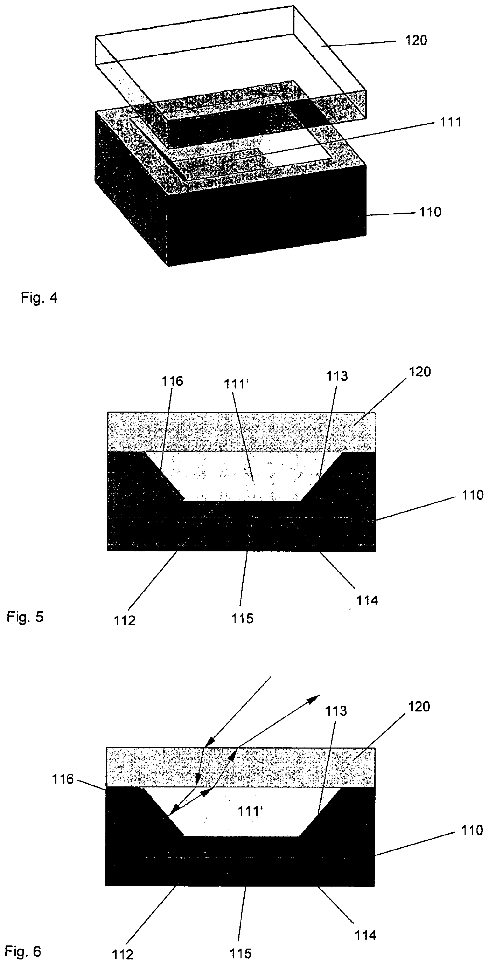

Die Figuren 4 bis 6 veranschaulichen den Aufbau einer zweiten Ausführungsform, bei der die Zelle aus zwei Substratschichten bzw. Substratebenen 110, 120 zusammengesetzt ist. In der unteren Substratschicht 110 befindet sich eine Aussparung 111. Im Gegensatz zu der zuvor beschriebenen ersten Ausführungsform reicht diese Aussparung nur bis zu einer bestimmten Tiefe in der Substratschicht 110. Die offene Seite der Aussparung wird durch die zweite Schicht 120 abgeschlossen. Der so gebildete Hohlraum wird im folgenden Kavität 111' genannt.

Neben der Deckschicht 120 besteht die Wandung der Kavität 111' aus dem in der Substratschicht 110 ausgebildeten Boden 112 und den ebenfalls in der Substratschicht 110 ausgebildeten Seitenwänden 113. Die Seitenwände 113 stehen derart unter einem Winkel zum Boden 112, dass sich die Kavität 111' in Richtung der Deckschicht 120 weitet. Bei diesem Winkel handelt es sich um den Ätzwinkel, der sich als Folge der Gitterstruktur des Substratmaterials bei nasschemischen Ätzverfahren einstellt.

Fig. 5 zeigt schematisch eine Diffusionssperre 114, die (in Fig. 5) unterhalb des Bodens 112 in der Substratschicht 110 vorgesehen ist. Der Bereich zwischen dem Boden 112 und der Diffusionsbarriere 114 dient als Reservoirbereich 115 zur Aufnahme des Reaktivgasmaterials.

In den Figuren 4 bis 6 besteht die Deckschicht 120 aus optisch durchlässigem Material, bspw. Glas. Zusätzlich ist im Seitenwandbereich 113 der Kavität 111' eine Reflektionsschicht 116 angebracht, so dass durch die Deckschicht 120 einfallende Lichtstrahlen an dieser reflektiert werden und von einem außerhalb der Zelle angeordneten Sensor detektiert werden können. Fig. 6 zeigt prinzipiell den Verlauf eines in die Kavität 111' einfallenden und an der Reflektionsschicht 116 reflektierten Lichtstrahls.

Nach einer weiteren, in den Figuren nicht dargestellten Ausführungsform ist es alternativ auch möglich, den Reservoirbereich mit der dazugehörigen Diffusionsbarriere im Seitenwandbereich 113 der Kavität 111' vorzusehen. In diesem Fall wird die Reflektionsschicht 116 im Bereich des Bodens 112 angebracht.

Wie im Zusammenhang mit dem ersten Ausführungsbeispiel beschrieben, erfolgt die Anreicherung des Reservoirbereichs 115 mit dem für die spätere Ausdiffusion bestimmten Material durch Ionenimplantation, und das anschließende hermetische Verschließen der Zelle durch Verbindung der Substratschicht 110 mit der Deckschicht 120 mittels Anodischen Bondens.

Zur Verwendung der Reaktivgaszelle wird diese mittels externer oder auch in die Zelle integrierter, in den Ausführungsformen nach den Figuren nicht explizit dargestellter Heizstrukturen in geeigneter Weise erhitzt, so dass das in den Reservoirbereichen 15, 115 eingelagerte Material aus diesen ausdiffundiert und sich in der Kavität 11', 111' der erwünschte Partialdruck des Reaktivgases einstellt.

Bei der Ausdiffusion des Reaktivgases verhindern die zuvor beschriebenen Diffusionssperren 14, 114 die Diffusion des Gases aus den Reservoirbereichen 15, 115 in die restliche Substratstruktur und geben der Gasdiffusion eine Vorzugsrichtung in Richtung der Kavität 11', 111'.

## Patentansprüche

1. Verfahren zur Herstellung einer Zelle mit einer Kavität (11'; 111') und einer die Kavität umgebenden Wandung (10, 20, 30; 110, 120) umfassend die folgenden Schritte
- Bereitstellen einer Wandung (10, 20, 30; 110, 120) mit einer Kavität,
- Deponieren von Material zur Bildung von Reaktivgas in einem Depotbereich in der Wandung (10, 20, 30; 110, 120) durch Ionenimplantation, das durch Diffusion in die Kavität (11'; 111') einbringbar ist,
- hermetisches Verschließen der Zelle mittels der Wandung,
- wobei die Wandung (10, 20, 30; 110, 120) der Zelle aus mindestens zwei Schichten aus Substratmaterial aufgebaut wird, von denen mindestens eine einen lichtdurchlässigen Bereich aufweist, so dass die Kavität für Lichtstrahlen zugänglich ist.

2. Verfahren nach Anspruch 1, **dadurch gekennzeichnet, dass** eine gewünschte Konzentration des die Kavität (11'; 111') befüllenden Gases eingestellt wird.

## Claims

1. Method of manufacturing a cell having a cavity (11'; 111') and a wall surrounding the cavity (10, 20, 30; 110, 120) comprising the steps of
- providing a wall (10, 20, 30; 110, 120) with a cavity,
- depositing material in a reservoir area in the wall (10, 20, 30; 110, 120) by ion implantation for formation of reactive gas, the material being introducible into the cavity (11'; 111') by diffusion,
- hermetically sealing the cell using the wall,
- wherein the wall (10, 20, 30; 110, 120) of the cell is formed of at least two layers of substrate material at least one of which includes a translucent area so that the cavity is accessible to light rays.

2. Method according to claim 1, **characterized in that** a desired concentration of the gas filling the cavity (11'; 111') is set.

## Revendications

1. Procédé de fabrication d'une cellule présentant une cavité (11'; 111') et une paroi (10, 20, 30; 110, 120) entourant la cavité, comprenant les étapes suivantes:
- préparation d'une paroi (10, 20, 30; 110, 120) avec une cavité,
- dépôt de matériau par implantation ionique dans une zone de dépôt de la paroi (10, 20, 30; 110, 120) pour formation de gaz reactif, ledit matériau pouvant pénétrer dans la cavité (11'; 111') par diffusion,
- fermeture hermétique de la cellule au moyen de la paroi,
- dans lequel la paroi (10, 20, 30; 110, 120) de la cellule est constituée d'au moins deux couches de matériau substrat, dont au moins une présente une zone transparente rendant la cavité accessible au rayonnement lumineux.

2. Procédé selon la revendication 1, **caractérisé en ce qu'**une concentration souhaitée est réglée pour le gaz remplissant la cavité (11'; 111').
